# EUROPEAN PATENT APPLICATION

(11) **EP 4 800 478 A1**
(43) Date of publication of application: **02.09.2026**
(21) Application number: 25160720.6
(22) Date of filing: 27.02.2025
(51) Int. Cl.: G03F 7/00

(54) **FLUID HANDLING STRUCTURE**

(71) Applicant: ASML Netherlands B.V., 5500 AH Veldhoven (NL)
(72) Inventor: VAN EEDEN, Bart, 5500 AH Veldhoven (NL); LUDICK, Luwan, 5500 AH Veldhoven (NL); HUANG, Yang-Shan, 5500 AH Veldhoven (NL); VAN DER VOORT, Dennis Dominic, 5500 AH Veldhoven (NL)
(74) Representative: ASML Netherlands B.V.

(57) **Abstract**

A fluid handling structure configured to confine immersion liquid to an immersion space and comprising:
a liquid supply opening to supply immersion liquid to the immersion space;
a extraction opening outwards of the liquid supply opening to extract fluid from the immersion space;
a gas supply opening outwards of the fluid extraction opening to supply a soluble gas to the vicinity of the immersion space; and
a gas extraction opening outwards of the gas supply opening to extract gas from the vicinity of the immersion space;
wherein the bottom surface has:
an outer portion outward of the gas extraction opening, the outer portion facing the substrate in use and separated from the substrate by a first distance; and
a barrier projecting toward the substrate by a second distance, the second distance being in the range of from 40% to 99% of the first distance.

## Description

### TECHNICAL FIELD

The present invention relates to a fluid handling structure and a method of confining immersion liquid.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer). Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm.

Further improvements in the resolution of smaller features may be achieved by providing an immersion fluid having a relatively high refractive index, such as water, on the substrate during exposure. The effect of the immersion fluid is to enable imaging of smaller features since the exposure radiation will have a shorter wavelength in the fluid than in gas. The effect of the immersion fluid may also be regarded as increasing the effective numerical aperture (NA) of the system and also increasing the depth of focus.

The immersion fluid may be confined to a localized area, referred to as an immersion space, between a liquid confinement structure of the lithographic apparatus and the substrate by a fluid handling system.

It is known to provide a local atmosphere in the vicinity of the immersion fluid of a soluble gas that easily dissolves in the immersion fluid, e.g. carbon dioxide (CO₂) if the immersion fluid is water. The effect of this is that any bubbles of gas from the local atmosphere that become entrained in the immersion fluid are likely to dissolve before they reach the beam path and thereby the occurrence of imaging defects due to bubbles is reduced. However, if the soluble gas escapes from the vicinity of the immersion fluid to the wider environment, problems may arise. For example, the soluble gas may have a different refractive index than the air in the lithographic apparatus and may therefore cause errors in optical sensors, such as interferometric position sensors. Also, the soluble gas may be toxic and so be a danger to human life if it escapes to the clean room in which the lithographic apparatus is used.

### SUMMARY

It is an aim of the present invention to provide a fluid handling structure and a method for confining immersion liquid which avoids or ameliorates the effects of soluble gas escaping from the vicinity of the immersion space.

According to the present invention, there is provided a fluid handling structure for an immersion lithographic apparatus, the fluid handling structure configured to confine immersion liquid to an immersion space between a bottom surface of the fluid handling structure and a surface of a substrate and/or a substrate support supporting the substrate, the fluid handling structure comprising: at least one liquid supply opening configured to supply immersion liquid to the immersion space; at least one fluid extraction opening radially outwards of the liquid supply opening and configured to extract fluid from the immersion space; at least one gas supply opening radially outwards of the fluid extraction opening and configured to supply a soluble gas to the vicinity of the immersion space; and at least one gas extraction opening radially outwards of the gas supply opening and configured to extract gas from the vicinity of the immersion space; wherein the bottom surface has: an outer portion radially outward of the gas extraction opening, the outer portion facing the substrate in use and separated from the substrate by a first distance; and a barrier projecting from the outer portion of the fluid handling structure toward the substrate by a second distance, the second distance being in the range of from 40% to 99% of the first distance.

According to the present invention there is provided a method of confining immersion liquid to an immersion space between a bottom surface of a fluid handling structure and a surface of a substrate and/or a substrate support supporting the substrate in an immersion lithographic apparatus, the method comprising:
supplying immersion liquid to the immersion space via at least one liquid supply opening;
supplying a soluble gas to the vicinity of the immersion space via at least one gas supply opening;
extracting gas from the vicinity of the immersion space via at least one gas extraction opening radially outwards of the gas supply opening; wherein the bottom surface has: an outer portion radially outward of the gas extraction opening, the outer bottom surface facing the substrate in use and
separated from the substrate by a first distance; and a barrier projecting from the outer portion of the fluid handling structure toward the substrate by a second distance, the second distance being in the range of from 40% to 99% of the first distance.

### BRIEF DESCRIPTION OF THE DRAWINGS

Embodiments of the invention will now be described, by way of example only, with reference to the accompanying schematic drawings, in which corresponding reference symbols indicate corresponding parts, and in which:
Figure 1 depicts the schematic overview of the lithographic apparatus;
Figures 2a, 2b, 2c and 2d each depict, in cross section, two different versions of a fluid handling system with different features illustrated on the left-hand side and the right-hand side of each version, which may extend around the complete circumference according to the prior art;
Figure 3 is a schematic view of openings at an underside of a fluid handling structure;
Figure 4 is a schematic cross-section of part of a fluid handling structure of an embodiment;
Figure 5 is a schematic cross-section of part of a fluid handling structure of a variant of the embodiment of Figure 4;
Figure 6 is a schematic cross-section of part of a fluid handling structure of another variant of the embodiment of Figure 4;
Figure 7 is a schematic cross-section of part of a fluid handling structure of another variant of the embodiment of Figure 4;
Figure 8 is a schematic cross-section of part of a fluid handling structure of another variant of the embodiment of Figure 4;
Figure 9 is a schematic cross-section of part of a fluid handling structure of another variant of the embodiment of Figure 4;
Figure 10 is a schematic cross-section of part of a fluid handling structure of another variant of the embodiment of Figure 4;
Figure 11 is a schematic cross-section of part of a fluid handling structure of another variant of the embodiment of Figure 4;
Figure 12 is a schematic cross-section of part of a fluid handling structure of another embodiment;
Figure 13 is a schematic cross-section of part of a fluid handling structure of a variant of the embodiment of Figure 12;
Figure 14 is a schematic cross-section of part of a fluid handling structure of another variant of the embodiment of Figure 12;
Figure 15 is a schematic cross-section of part of a fluid handling structure of another variant of the embodiment of Figure 12;
Figure 16 is a schematic cross-section of part of a fluid handling structure of another variant of the embodiment of Figure 12;
Figure 17 is a schematic cross-section of part of a fluid handling structure of another variant of the embodiment of Figure 12;
Figure 18 is a schematic cross-section of part of a fluid handling structure of another variant of the embodiment of Figure 12;
Figure 19 is a schematic cross-section of part of a fluid handling structure of another variant of the embodiment of Figure 12;
Figure 20 is a schematic cross-section of part of a fluid handling structure of an embodiment;
Figure 21 is a schematic cross-section of part of a fluid handling structure of a variant of the embodiment of Figure 20;
Figure 22 is a schematic cross section o- part of a fluid handling structure of another variant of the embodiment of Figure 20;
Figure 23 is a schematic cross-section of part of a fluid handling structure of another variant of the embodiment of Figure 20;
Figure 24 is a schematic cross-section of part of a fluid handling structure of another variant of the embodiment of Figure 20;
Figure 25 is a schematic cross-section of part of a fluid handling structure of another variant of the embodiment of Figure 20;
Figure 26 is a schematic cross-section of part of a fluid handling structure of another variant of the embodiment of Figure 20;
Figure 27 is a schematic cross-section of part of a fluid handling structure of another variant of the embodiment of Figure 20;
Figure 28 is a schematic cross-section of a part of a fluid handling structure of an embodiment;
Figure 29 is a schematic cross-section of a part of a fluid handling structure of a variant of the embodiment of Figure 28;
Figure 30 is a schematic cross-section of a part of a fluid handling structure of another variant of the embodiment of Figure 28;
Figure 31 is a schematic cross-section of a part of a fluid handling structure of an embodiment; and
Figure 32 is a schematic cross-section of a part of a fluid handling structure of a variant of the embodiment of Figure 31.

The features shown in the figures are not necessarily to scale, and the size and/or arrangement depicted is not limiting. It will be understood that the figures include optional features which may not be essential to the invention. Furthermore, not all of the features of the apparatus are depicted in each of the figures, and the figures may only show some of the components relevant for describing a particular feature.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

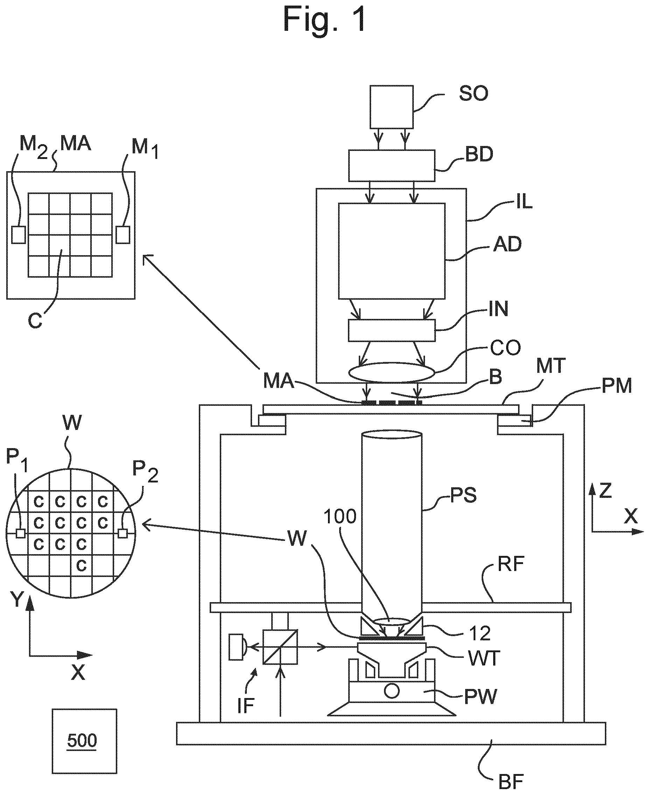

Figure 1 schematically depicts a lithographic apparatus. The lithographic apparatus includes an illumination system (also referred to as illuminator) IL configured to condition a radiation beam B (e.g., UV radiation or DUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a substrate table) WT constructed to hold a substrate (e.g., a resist coated wafer) W and connected to a second positioner PW configured to accurately position the substrate support WT in accordance with certain parameters, and a projection system (e.g., a refractive projection lens system) PS configured to project a pattern imparted to the radiation beam B by patterning device MA onto a target portion C (e.g., comprising one or more dies) of the substrate W. A controller 500 controls the overall operation of the apparatus. Controller 500 may be a centralised control system or a system of multiple separate sub-controllers within various sub-systems of the lithographic apparatus.

In operation, the illumination system IL receives the radiation beam B from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

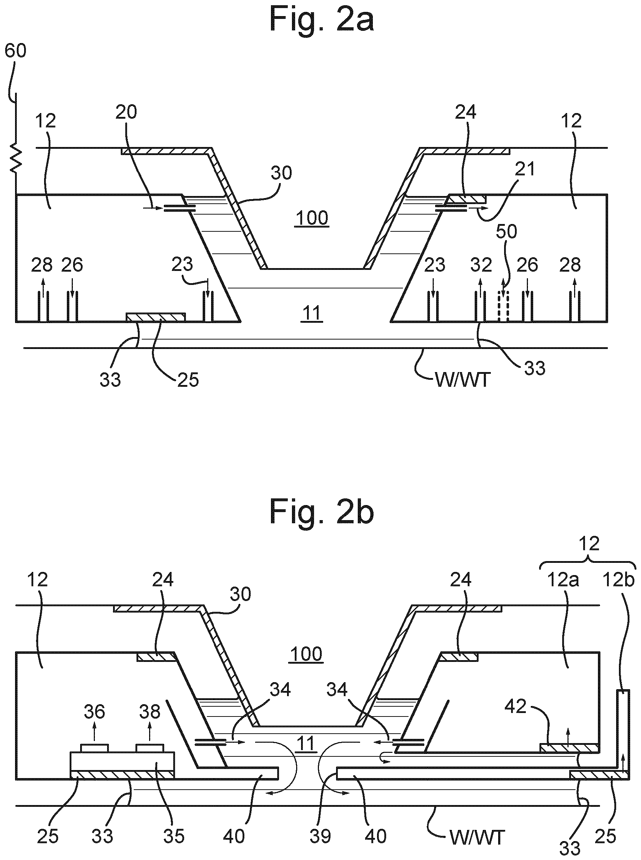

The lithographic apparatus is of a type wherein at least a portion of the substrate W may be covered by an immersion liquid having a relatively high refractive index, e.g., water, so as Figure 2a shows a fluid handling system comprising a fluid handling structure 12 around the bottom surface of the final element 100. The final element 100 has an inverted frusto-conical shape. The frusto-conical shape having a planar bottom surface and a conical surface. The frusto-conical shape protrudes from a planar surface and having a bottom planar surface. The bottom planar surface is the optically active portion of the bottom surface of the final element 100, through which the radiation beam B may pass. The final element 100 may have a coating 30. The fluid handling structure 12 surrounds at least part of the frusto-conical shape. The fluid handling structure 12 has an inner-surface which faces towards the conical surface of the frusto-conical shape. The inner-surface and the conical surface may have complementary shapes. A top surface of the fluid handling structure 12 may be substantially planar. The fluid handling structure 12 may fit around the frusto-conical shape of the final element 100. A bottom surface of the fluid handling structure 12 may be substantially planar and in use the bottom surface may be parallel with the facing surface of the substrate support WT and/or substrate W. Thus, the bottom surface of the fluid handling structure 12 may be referred to as a surface facing the surface of the substrate W. The distance between the bottom surface and the facing surface may be in the range of 20 to 500 micrometers, desirably in the range of 70 to 200 micrometers.

The fluid handling structure 12 extends closer to the facing surface of the substrate W and substrate support WT than the final element 100. The immersion space 11 is therefore defined between the inner surface of the fluid handling structure 12, the planar surface of the frusto-conical portion and the facing surface. During use, the immersion space 11 is filled with immersion liquid. The immersion liquid fills at least part of a buffer space between the complementary surfaces between the final element 100 and the fluid handling structure 12, in an embodiment at least part of the space between the complementary inner-surface and the conical surface.

The immersion liquid is supplied to the immersion space 11 through an opening formed in a surface of the fluid handling structure 12. The immersion liquid may be supplied through a supply opening 20 in the inner-surface of the fluid handling structure 12. Alternatively or additionally, the immersion liquid is supplied from a liquid supply opening 23 (which may be referred to as an under supply opening) formed in the bottom surface of the fluid handling structure 12. The liquid supply opening 23 may surround the path of the radiation beam B and it may be formed of a series of openings in an array or a single slit. The immersion liquid is supplied to fill the immersion space 11 so that flow through the immersion space 11 under the projection system PS is laminar. The supply of the immersion liquid from the liquid supply opening 23 additionally reduces the ingress of bubbles into the immersion space 11. This supply of the immersion liquid may function as a liquid seal.

The immersion liquid may be recovered from a recovery opening 21 formed in the inner-surface. The recovery of the immersion liquid through the recovery opening 21 may be by application of an underpressure; the recovery through the recovery opening 21 as a consequence of the velocity of the immersion liquid flow through the immersion space 11; or the recovery may be as a consequence of both. The recovery opening 21 may be located on the opposite side of the supply opening 20, when viewed in plan. Additionally or alternatively, the immersion liquid may be recovered through an overflow recovery 24 located on the top surface of the fluid handling structure 12. The supply opening 20 and recovery opening 21 can have their function swapped (i.e. the flow direction of liquid is reversed). This allows the direction of flow to be changed depending upon the relative motion of the fluid handling structure 12 and substrate W.

Additionally or alternatively, immersion liquid may be recovered from under the fluid handling structure 12 through a recovery opening 25 formed in its bottom surface. The recovery opening 25 may serve to hold a meniscus 33 of the immersion liquid to the fluid handling structure 12. The meniscus 33 forms between the fluid handling structure 12 and the facing surface and it serves as border between the liquid space and the gaseous external environment. The recovery opening 25 may be a porous plate which may recover the immersion liquid in a substantially single phase flow. The recovery opening in the bottom surface may be a series of fluid extraction openings 32 (which may be referred to as pinning openings) through which the immersion liquid is recovered. The fluid extraction openings 32 may recover the immersion liquid in a two phase flow.

Optionally radially outward, with respect to the inner-surface of the fluid handling structure 12, is a gas supply opening 26 (which may be referred to as a gas knife opening). Gas may be supplied through the gas supply opening 26 at elevated speed to assist liquid confinement of the immersion liquid in the immersion space 11. The supplied gas may be humidified and it may contain substantially carbon dioxide. Radially outward of the gas supply opening 26 is a gas recovery opening 28 for recovering the gas supplied through the gas supply opening 26. In an embodiment, a step or a slope may be present between gas supply opening 26 and gas recovery opening 28. An additional fluid extraction opening may be formed in the step or slope between gas supply opening 26 and gas recovery opening 28.

Further openings, for example open to atmosphere or to a gas source or to a vacuum, may be present in the bottom surface of the fluid handling structure 12, i.e. in the surface of the fluid handling structure 12 facing the substrate W. An example of such an optional further opening 50 is shown in dashed lines on the right hand side of Figure 2a. As shown, the further opening 50 may be a supply or extraction member, which is indicated by the double-headed arrow. For example, if configured as a supply, the further opening 50 may be connected to a liquid supply or a gas supply as with any of the supply members. If the further opening 50 is configured as a supply and a step or a slope is present between gas supply opening 26 and gas recovery opening 28, gas supply opening 26 may be positioned at a higher location than the further opening 50 and gas recovery opening 28 may be located at a higher location than gas supply opening 26. In an embodiment, a step or a slope may be present between the further opening 50 and gas recovery opening 28. Alternatively, if the further opening 50 is configured as an extraction, the further opening 50 may be used to extract fluid, and may for example, be connected to atmosphere or to a gas source or to a vacuum. For example, the at least one further opening 50 may be present between gas supply opening 26 and gas recovery opening 28, and/or between fluid extraction openings 32 and gas supply opening 26. In Figure 2a, the further opening 50 is radially inward of the gas supply opening 26. Alternatively, the further opening 50 may be located radially outward of the gas recovery opening 28, or radially between the gas supply opening 26 and the gas recovery opening 28.

The two different versions of the fluid handling structure 12 of the left and right sides of Figure 2a pin the meniscus 33. The version of the fluid handling structure 12 on the right hand side of Figure 2a may pin the meniscus 33 at a position that is substantially fixed with respect to the final element 100, due to the fixed position of the fluid extraction opening 32. The version of the fluid handling structure 12 on the left hand side of Figure 2a may pin the meniscus 33 below the recovery opening 25, and thus the meniscus 33 may move along the length and/or width of the recovery opening 25. For the radiation beam B to be directed to a full side of the substrate W under exposure, the substrate support WT supporting the substrate W is moved relative to the projection system PS. To maximize the output of substrates W exposed by the lithographic apparatus, the substrate support WT (and so substrate W) is moved as fast as possible. However, there is a critical relative speed (often referred to as a critical scan speed) above which the meniscus 33 between the fluid handling structure 12 and the substrate W becomes unstable. An unstable meniscus 33 has a greater risk of losing immersion liquid, for example in the form of one or more droplets. Furthermore, an unstable meniscus 33 has a greater risk of resulting in the inclusion of gas bubbles in the immersion liquid, especially when the confined immersion liquid crosses the edge of the substrate W.

A droplet present on the surface of the substrate W may apply a thermal load and may be a source of defectivity. The droplet may evaporate leaving a drying stain, it may move transporting contamination such as a particle, it may collide with a larger body of immersion liquid introducing a bubble of gas into the larger body and it may evaporate, applying the thermal heat load to the surface on which it is located. Such a thermal load could be a cause of distortion and/or a source of a positioning error if the surface is associated with positioning of components of the lithographic apparatus relative to the substrate W being imaged. A formation of a droplet on a surface is therefore is undesirable. To avoid formation of such a droplet, the speed of the substrate support WT is thus limited to the critical scan speed at which the meniscus 33 remains stable. This limits the throughput of the lithographic apparatus.

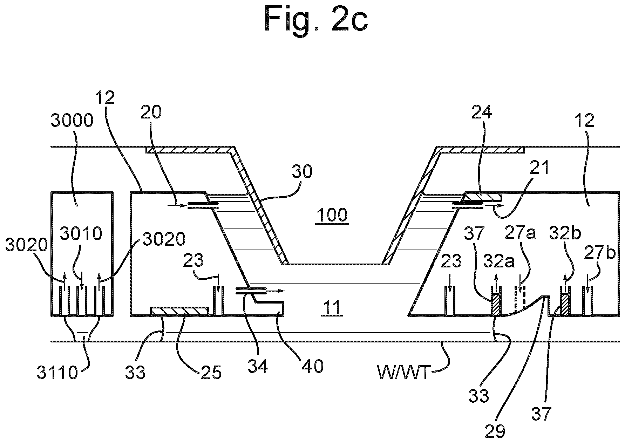

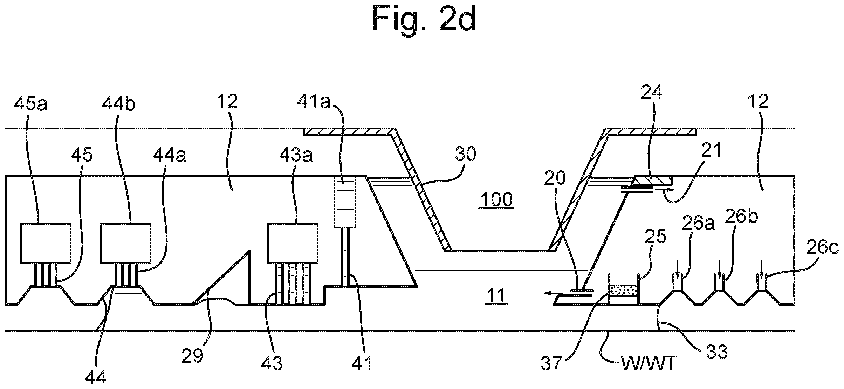

The left hand side of the fluid handling system in Figure 2a may comprise a spring 60. The spring 60 may be an adjustable passive spring configured to apply a biasing force to the fluid handling structure 12 in the direction of the substrate W. Thus, the spring 60 can be used to control the height of the fluid handling structure 12 above the substrate W. Such adjustable passive springs are described in US 7,199,874 which is herein incorporated by reference in its entirety. Other bias devices may also be appropriate, for example, using an electromagnetic force. Although the spring 60 is shown with the left hand side of Figure 2a, it is optional and does not need to be included with the other features of the left hand side of Figure 2a. The spring 60 is not shown on any of the other figures, but could also be included with the other variations of the fluid handling system described in relation to Figures 2a, 2b, 2c, or 2d.

Figure 2b shows two different versions of the fluid handling structure 12 on its left side and on its right side, which allow movement of the meniscus 33 with respect to the final element 100. The meniscus 33 may move in the direction of the moving substrate W. This decreases the relative speed between the meniscus 33 and the moving substrate W, which may result in improved stability and a reduced risk of breakdown of the meniscus 33. The speed of the substrate W at which the meniscus 33 breaks down is increased so as to allow faster movement of the substrate W under the projection system PS. Throughput is thus increased.

Features shown in Figure 2b which are common to Figure 2a share the same reference numbers. The fluid handling structure 12 has an inner surface which complements the conical surface of the frusto-conical shape. The bottom surface of the fluid handling structure 12 is closer to the facing surface than the bottom planar surface of the frusto-conical shape.

Immersion liquid is supplied to the immersion space 11 through supply openings 34 formed in the inner surface of the fluid handling structure 12. The supply openings 34 are located towards the bottom of the inner surface, perhaps below the bottom surface of the frusto-conical shape. The supply openings 34 are located around the inner surface, spaced apart around the path of the radiation beam B.

Immersion liquid is recovered from the immersion space 11 through recovery openings 25, in the bottom surface of the fluid handling structure 12. As the facing surface moves under the fluid handling structure 12, the meniscus 33 may migrate over the surface of the recovery opening 25 in the same direction as the movement of the facing surface. The recovery openings 25 may be formed of a porous member. The immersion liquid may be recovered in single phase. The immersion liquid may be recovered in a two phase flow. The two phase flow is received in a chamber 35 within the fluid handling structure 12 where it is separated into liquid and gas. The liquid and gas are recovered through separate channels 36, 38 from the chamber 35.

An inner periphery 39 of the bottom surface of fluid handling structure 12 extends into the immersion space 11 away from the inner surface to form a plate 40. The inner periphery 39 forms a small aperture which may be sized to match the shape and size of the radiation beam B. The plate 40 may serve to isolate the immersion liquid at either side of it. The supplied immersion liquid flows inwards towards the aperture, through the inner aperture and then under the plate 40 radially outwardly towards the surrounding the recovery openings 25.

The fluid handling structure 12 may be in two parts as shown on the right hand side of Figure 2b: an inner part 12a and an outer part 12b. The inner part 12a and the outer part 12b may move relatively to each other, mainly in a plane parallel to facing surface. The inner part 12a may have the supply openings 34 and it may have the overflow recovery 24. The outer part 12b may have the plate 40 and the recovery opening 25. The inner part 12a may have an intermediate recovery 42 for recovering the immersion liquid which flows between the inner part 12a and the outer part 12b.

The two different versions of the fluid handling structure 12 of Figure 2b thus allow for movement of the meniscus 33 in the same direction as the substrate W, enabling faster scan speeds and increased throughput of the lithographic apparatus. However, the migration speed of meniscus 33 over the surface of the recovery opening 25 in the fluid handling structure 12 of the left side of Figure 2b may be slow. The fluid handling structure 12 of the right side of Figure 2b allows for quicker movement of the meniscus 33, by moving the outer part 12b with respect to the inner part 12a and the final element 100. However, it may be difficult to control the intermediate recovery 42 so as to ensure that enough immersion liquid is provided between the inner part 12a and the outer part 12b to prevent contact therebetween.

Figure 2c shows two different versions of the fluid handling structure 12 on its left side and on its right side, which may be used to pin the meniscus 33 of the immersion liquid to the fluid handling structure 12 as described above in relation to Figures 2a and/or 2b. Features shown in Figure 2c which are common to Figures 2a and/or 2b share the same reference numbers.

The fluid handling structure 12 has an inner surface which compliments the conical surface of the frusto-chronical shape. The bottom surface of the fluid handling structure 12 is closer to the facing surface than the bottom planar surface of the frusto-chronical shape. Immersion liquid is supplied to the immersion space 11 delivered through an opening formed in a surface of the fluid handling structure 12. The immersion liquid may be supplied through a supply opening 34 in the inner surface of the fluid structure 12. Alternatively or additionally, the immersion liquid may be supplied through a supply opening 20 in the inner surface of the fluid structure 12. Alternatively or additionally, the immersion liquid is supplied through the liquid supply opening 23. The immersion liquid may be recovered via an extraction member, for example, via recovery opening 21 formed in the inner-surface and/or overflow recovery 24 and/or one or more openings in a surface of the fluid handling structure 12 as described below.

The two different versions of the fluid handling structure 12 of the left and right sides of Figure 2c pin the meniscus 33. The version of the fluid handling structure 12 on the right hand side of Figure 2c may pin the meniscus 33 at a position that is substantially fixed with respect to the final element 100, due to the fixed position of the recovery opening 32a. The version of the fluid handling structure 12 on the left hand side of Figure 2c may pin the meniscus 33 below the recovery opening 25, and thus the meniscus 33 may move along the length and/or width of the recovery opening 25.

As described above in relation to Figure 2b, an inner periphery of the bottom surface of fluid handling structure 12 may extends into the immersion space 11 away from the inner surface to form a plate 40 as shown on the left hand side. As described above, this may form a small aperture, and may isolate the immersion liquid at either side and/or cause immersion liquid to flow inwards towards the aperture, through the inner aperture and then under the plate 40 radially outwardly towards the surrounding the recovery openings 25. Although this features is shown on the left hand side in Figure 2c, it is optional in combination with the other features shown. Preferably, as shown on the left hand side, immersion liquid is supplied to the immersion space 11 through supply openings 34 formed in the inner surface of the fluid handling structure 12. The supply openings 34 are located towards the bottom of the inner surface, perhaps below the bottom surface of the frusto-conical shape. The supply openings 34 are located around the inner surface, spaced apart around the path of the radiation beam B. Alternatively or additionally, the immersion liquid may be supplied through a supply opening 20 in the inner surface of the fluid structure 12. Alternatively or additionally, the immersion liquid is supplied through the liquid supply opening 23. Although the supply openings 34 are the preferred liquid supply, any combination of supply openings 34, supply openings 20 and/or liquid supply openings 23 may be provided.

As shown on the left hand side of Figure 2c, a fluid handling system may comprise the fluid handling structure 12 as described above and a further device 3000. The fluid handling structure 12 may have an extraction member, such as recovery opening 25, and a liquid supply opening, such as the liquid supply opening 23. It will be understood that the fluid handling structure 12 may comprise any configuration as disclosed in relation to the left hand of Figure 2a, the right hand side of Figure 2a, the left hand side of Figure 2b, the right hand side of Figure 2b or (as described below) the right hand side of Figure 2c, in combination with the further device 3000.

The further device 3000 may otherwise be referred to as a droplet catcher. The further device 3000 is provided to reduce occurrence of liquid on the surface of the substrate W after the fluid handling structure 12 has moved over the surface. The further device 3000 may comprise a liquid supply member 3010 and at least one extraction member 3020. The at least one extraction member 3020 may be formed in a shape surrounding the at least one supply member 3010 in plan. The at least one liquid supply member 3010 may be configured to provide a further liquid to a space 3110 between at least a part of the further device 3000 and the surface of the substrate W. The further device 3000 may be configured to recover at least some of the liquid via the at least one extraction member 3020. The further device 3000 may be used to incorporate any liquid left on the surface of the substrate W with the liquid in the space 3110 and then use the further device 3000 to extract the liquid such that the amount of liquid remaining on the surface of the substrate W is reduced.

The further device 3000 is shown as a separate device from the fluid handling structure 12 in Figure 2c. The further device 3000 may be positioned adjacent to the fluid handling structure 12. Alternatively, the further device 3000 may be part of, i.e. integral to, the fluid handling structure 12.

The further device 3000 may be configured to provide a liquid to the space 3110 which is separate from the liquid provided by the fluid handling structure 12.

Additionally or alternatively, the fluid handling structure 12 may have the components as shown on the right hand side of Figure 2c. More specifically, the fluid handling structure 12 may comprise the at least one liquid supply member, two extraction members (e.g., recovery openings 32a and 32b) and two gas supply members (e.g., gas supply openings 27a and 27b) formed on the surface of the fluid handling structure 12. Gas supply opening 27a can be omitted, i.e. is optional. The at least one liquid supply member may be the same as the liquid supply opening 23 in the bottom surface of the fluid handling structure 12 described above or the supply opening 20 or liquid supply openings 34 formed on the inner surface of the fluid handling structure 12 described in relation to left hand side of Figure 2b. The liquid supply member, the extraction members and the gas supply members may be formed on the surface of the fluid handling structure 12. Specifically, these components may be formed on a surface of the fluid handling structure 12 facing the substrate W, i.e. the bottom surface of the fluid handling structure 12.

At least one of the two extraction members may comprise a porous material 37 therein. The porous material 37 may be provided within an opening, e.g., recovery opening 32a through which fluid handling structure 12 extracts fluid from below the fluid handling structure 12 and may recover the immersion liquid in a single phase flow. The other of the two extraction members, e.g., recovery opening 32b may recover the immersion fluid as a dual phase extractor. The porous material 37 does not need to be flush with the bottom surface of the fluid handling structure 12.

Specifically, the fluid handling structure 12 may comprise the liquid supply member (e.g., liquid supply opening 23), with a first extraction member (e.g., recovery opening 32a) radially outwards of the liquid supply member, and a first gas supply member (e.g., gas supply opening 27a) radially outwards of the first extraction member, and the second extraction member (e.g., recovery opening 32b) radially outwards of the first gas supply member, and a second gas supply member (e.g., gas supply opening 27b) radially outwards of the second extraction member. Similar to Figure 2a, further openings, for example open to atmosphere or to a gas source or to a vacuum, may be present in the bottom surface of the fluid handling structure 12 as described previously (in relation to the fluid handling structure 12).

For example, at least one further opening (not shown) may be provided in the bottom surface of the fluid handling structure 12. The further opening is optional. The further opening may be arranged between the first extraction member (e.g., recovery opening 32a) and the first gas supply member (e.g., gas supply opening 27a) as described in the arrangement above. Alternatively or additionally, the further opening may be arranged between the second extraction member (e.g., recovery opening 32b) and the second gas supply member (e.g., gas supply opening 27b) as described in the arrangement above. The further opening may be the same as further opening 50 described above.

Optionally, the fluid handling structure 12 comprises a recess 29. The recess 29 may be provided between the recovery opening 32a and recovery opening 32b or gas supply opening 27a and recovery opening 32b. The shape of the recess 29 may be uniform around the fluid handling structure 12 and may optionally contain an inclined surface. In the case of the recess 29 provided between the recovery opening 32a and recovery opening 32b, the gas supply opening 27b may be provided on the inclined surface as shown in Figure 2c. In the case of the recess 29 provided between the gas supply opening 27a and recovery opening 32b, the gas supply opening 27b may be provided on the inclined surface or a part of the bottom surface of the fluid handling structure 12 which is parallel to the surface of the substrate W. Alternatively, the shape of the recess 29 may vary around the circumference of the fluid handling structure 12. The shape of the recess 29 may be varied to alter the impact of gas supplied from the gas supply members on the fluid below the fluid handling structure 12.

Figure 2d shows, in its left and right halves, two different versions of the fluid handling structure 12. The fluid handling structure 12 of the left half of Figure 2d has a liquid injection buffer 41a, which holds a buffer amount of immersion liquid, and liquid injection holes 41 which supply immersion liquid from the liquid injection buffer to the immersion space 11. Outwardly of the liquid injection holes 41 are inner liquid recovery apertures 43 for conducting liquid to an inner recovery buffer 43a which is provided with a porous member. A recess 29 similar to that described relating to Figure 2c is provided outward of the inner liquid recovery apertures 43. Outward of the recess 29, in the lower face of the fluid handling structure 12 is a gas guiding groove 44 into which open outer recovery holes 44a. The outer recovery holes 44a lead a two-phase recovery flow to outer recovery buffer 44b which is also provided with a porous member. Outermost are gas sealing holes 45 which communicate between a gas sealing buffer volume 45a and the space underneath the fluid handling structure 12 to provide a gas flow to contain the immersion liquid.

The fluid handling structure 12 of the right half of Figure 2d has a supply opening 20 in the inner inclined face thereof. In the underside of the fluid handling structure 12 there are (from inner side to outer side) a recovery opening 25 provided with a porous member 37; a first gas supply opening 26a, a second gas supply opening 26b and a third gas supply opening 26c. Each of these openings opens into a groove in the underside of the fluid handling structure 12 that provides a buffer volume. The outermost part of the fluid handling structure 12 is stepped so as to provide a greater separation between the fluid handling structure 12 and the substrate W.

Figures 2a-2d show examples of different configurations which can be used as part of a fluid handling system. It will be understood that the examples provided above refer to specific extraction members and recovery members, but it is not necessary to use the exact type of extraction member and/or recovery member. In some cases different terminology is used to indicate the position of the member, but the same functional features may be provided. Examples of the extraction member referred to above include recovery opening 21, overflow recover 24, recovery opening 25 (possibly comprising a porous plate and/or the chamber 35), gas recovery opening 28, fluid extraction opening 32, recovery opening 32a, recovery opening 32b and/or the intermediate recovery 42. Examples of the supply member referred to above include supply opening 20, liquid supply opening 23, gas supply opening 26, gas supply opening 27a, gas supply opening 27b, and/or supply openings 34. In general, an extraction member used to extract/recover fluid, liquid or gas is interchangeable with at least any of the other examples used which extract/recover fluid, liquid or gas respectively. Similarly, a supply member used to supply fluid, liquid or gas is interchangeable with at least any of the other examples used which supply fluid, liquid or gas respectively. The extraction member may extract/recover fluid, liquid or gas from a space by being connected to an underpressure which draws the fluid, liquid or gas into the extraction member. The supply member may supply fluid, liquid or gas to the space by being connected to a relevant supply.

According to the present invention, there is provided a fluid handling system comprising a fluid handling structure configured to at least partly confine a liquid to an immersion space between a final (optical) element and a substrate.

As mentioned with reference to Figures 2a-2d, the fluid handling structure 12 confines the immersion fluid to an immersion space 11 between a final element 100 and a substrate W. The substrate W is moved relative to the fluid handling structure 12 during a lithographic processing step.

When a substrate W is moved relative to the fluid handling structure 12, the substrate W has a receding side and an advancing side. The receding side is the part of the substrate W which is moving away from the centre of the immersion space 11, and the advancing side is the part of the substrate which is moving towards the centre of the immersion space 11. This also means that when the fluid handling structure 12 is moved relative to the substrate W, the fluid handling structure 12 has a receding side and an advancing side. In this case, the receding side of the fluid handling structure is the part of the fluid handling structure 12 which is moving towards the centre of the immersion space 11, and the advancing side is the part of the fluid handling structure 12 which is moving away the centre of the immersion space 11.

As shown in, for example, Figure 2a, in an embodiment the fluid handling structure 12 comprises at least one liquid supply opening 23. The liquid supply opening 23 is configured to supply immersion liquid to the immersion space 11. In an embodiment the fluid handling structure 12 comprises a plurality of the liquid supply opening 23. The liquid supply openings 23 may be arranged to form a geometrical shape, for example a circle, an oval, or a diamond.

As shown in Figure 2a, in an embodiment the fluid handling structure 12 comprises at least one fluid extraction opening 32. The fluid extraction opening 32 is radially outwards of the liquid supply opening 23. The fluid extraction opening 32 is configured to extract fluid from the immersion space 11. Immersion liquid may be extracted from the substrate W with the fluid extraction opening 32. This may be done using a two-phase flow. The fluid extraction opening 32 may be configured to extract gas and liquid.

As shown in Figure 2a, for example, in an embodiment the fluid handling structure 12 is configured such that the openings are separated from the substrate W and/or substrate support WT by a separation distance. The separation distance may vary at different locations of the fluid handling structure 12.

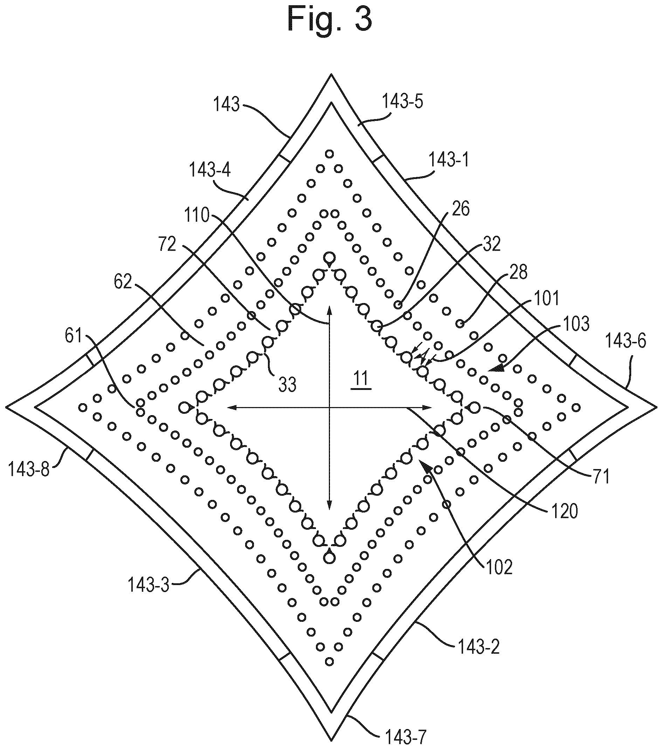

Figure 3 is a schematic view of openings at the underside of the fluid handling structure 12. As shown in Figure 3, in an embodiment the at least one fluid extraction opening 32 is arranged as a fluid extraction shape 102. In an embodiment the fluid handling structure 12 comprises a plurality of fluid extraction openings 32. The fluid extraction openings 32 may be arranged in an array. In an embodiment at least one fluid extraction opening 32 may be a slit opening (i.e. continuous).

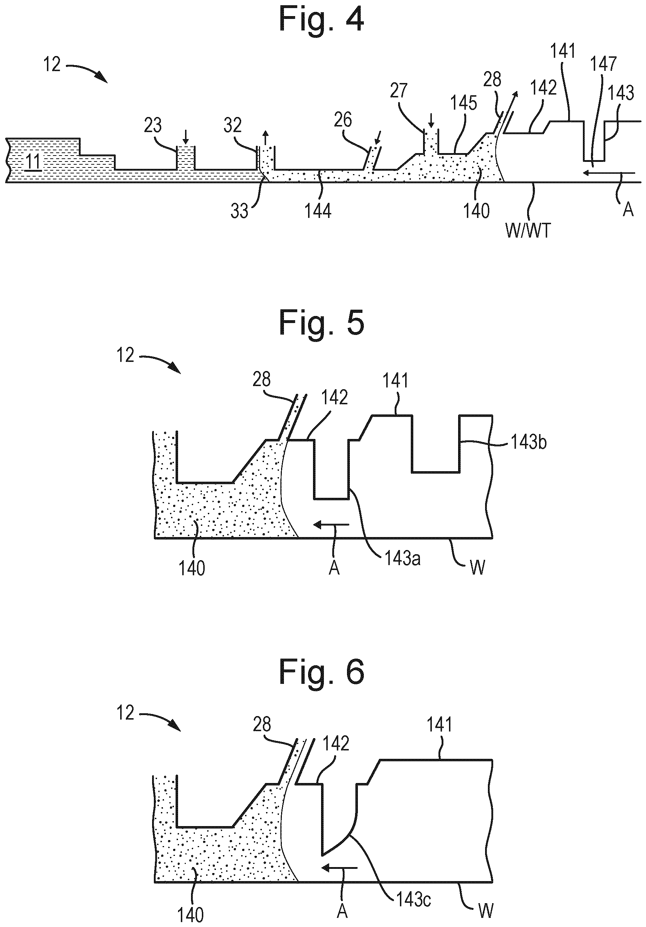

As shown in Figure 3, in an embodiment the fluid extraction shape 102 is defined by a plurality of sides 72 (see Figure 4 and Figure 5) and corners 71 (see Figure 4 and Figure 5). The corners 71 are between the plurality of sides 72. As shown in Figure 3, in an embodiment the corners 71 are geometrically relatively sharp corners. In an alternative arrangement, the corners 71 may be rounded. For example, the corners 71 may be the parts of the fluid extraction shape 102 that are at the most extreme ends of the fluid extraction shape 102 along the principal axes 110, 120 of the fluid extraction shape 102. The principal axes 110, 120 may be aligned with the major directions of travel of the substrate W under the fluid handling structure 12.

In the arrangement shown in Figure 3, the fluid extraction shape 102 may be substantially a diamond shape having concave sides. In an alternative arrangement, the fluid extraction shape 102 may be defined by smoother contours. For example, the fluid extraction shape 102 may be an ellipse. The extremes of the ellipse along the principal axes 110, 120 may form the corners 71 of the fluid extraction shape 102.

As shown in Figure 2a, in an embodiment the fluid handling structure 12 comprises at least one gas supply opening 26. In an embodiment the fluid handling structure 12 comprises a plurality of gas supply openings 26. The gas supply opening 26 is radially outwards of the fluid extraction opening 32. The gas supply opening 26 is configured to supply a gas to the immersion space 11. In an embodiment at least one of the gas supply openings 26 may be a slit opening (e.g. a continuous linear opening). Alternatively, the gas supply openings 26 may be substantially round, as shown in Figure 3, for example.

As shown in Figure 3, in an embodiment the at least one gas supply opening 26 is arranged as a gas supply shape 103. In an embodiment the gas supply shape 103 surrounds the fluid extraction shape 102. As shown in Figure 3, in an embodiment the gas supply shape 103 matches the fluid extraction shape 102. The gas supply shape 103 may be substantially the same as the fluid extraction shape 102 except that the gas supply shape 103 is bigger than the fluid extraction shape 102. However, it is not essential for the gas supply shape 103 to match the fluid extraction shape 102. In an alternative embodiment, the gas supply shape 103 may be shaped differently from the fluid extraction shape 102. For example, the gas supply shape 103 may be circular, oval shaped, square or rectangular.

As shown in Figure 3, in an embodiment the gas supply shape 103 comprises sides 62 and corners 61 between the sides 62. The corners 61 of the gas supply shape 103 may correspond to the extremes of the gas supply shape 103 along the principal axes 110, 120.

In an embodiment each fluid extraction opening 32 is configured to extract a mixture of liquid and gas, i.e., two phase flow. The liquid is extracted from the immersion space 11. The gas is extracted from the atmosphere on the other side of the fluid extraction openings 32 to the liquid. This creates a gas flow 101 as illustrated by arrows. The gas flow 101 is effective to pin the meniscus 33 between the fluid extraction openings 32 substantially in place. The gas flow 101 helps maintain the liquid confined by momentum blocking, by a gas flow induced pressure gradient and/or by drag (shear) of the gas flow 101 on the liquid.

Figure 3 also indicates the outline of a barrier 143 which projects towards the substrate W from the bottom surface of the fluid handling structure 12. The purpose of the barrier 143 is to control movement of gas that is provided to the vicinity of the immersion space 11 via gas supply openings 26. Barrier 143 projects from an first outer portion 141, second outer portion 142 of the bottom surface of the fluid handling structure 12, which is that part of the bottom surface that is outside the gas recovery openings 28. The first outer portion 141, second outer portion 142 may be further from the substrate W than other parts of the bottom surface of the fluid handling structure 12. The first outer portion 141, second outer portion 142 may comprise an first outer portion 141 and a second outer portion 142 which are at different distances form the substrate W. The transition between first outer portion 141 and second outer portion 142 may be stepped or sloped. The first outer portion 141 may be further from the centre of the immersion space 11 in the radial direction and further from the substrate W in the vertical direction than the second outer portion 142.

Barrier 143 may completely surround the gas supply shape 103. Alternatively, it may be provided only in selected places. For example, the barrier 143 may be provided only as side portions 143-1 to 143-4 that extend along sides 62 of the gas supply shape 103. Side portions 143-1 to 143-4 of barrier 143 may extend along at least 75% to the sides 62 of the gas supply shape 103. Corner portions 143-5 to 143-8 of barrier 143 may be provided at corners 61 of the gas supply shape 103. Alternatively, only the corner portions 143-5, 143-7 in the main scan direction 110 may be provided. Corner portions 143-6 to 143-8 may be provided without side portions 143-1 to 143-4. Some corner portions 143-6 to 143-8 and/or some side portions 143-1 to 143-4 may be provided. Barrier 143 may be provided at the locations where it is most required, as discussed below.

As mentioned, the purpose of barrier 143 is to control movement of gas supplied to the vicinity of the immersion space 11 and the movement of air from the environment toward the vicinity of the immersion space 11. The gas supplied to the vicinity of the immersion space 11 may be a gas that is soluble in the immersion liquid. For example, if the immersion liquid is water, the gas may be carbon dioxide. It is desirable to prevent or limit escape of the soluble gas from the vicinity of the immersion space 11 to the wider environment in the remainder of the lithographic apparatus or even outside of the lithographic apparatus. For example, if the soluble gas has a different refractive index than air, the presence of the soluble gas elsewhere in the lithographic apparatus may be detrimental to the performance of optical sensors, for example interferometric displacement measuring sensors. The soluble gas may be toxic in which case it is desirable to ensure that amounts of the soluble gas escaping from the lithographic apparatus are within safe limits. In some cases, during scanning the immersion liquid moves toward the receding side due to drag by the substrate W. This can result in the fluid extraction openings 32 being able to extract less soluble gas and so more gas flows to the gas recovery opening 28. Potentially gas recovery openings 28 may not be able to extract all the soluble gas at high scan speeds.

The effect of the barrier 143 is described with reference to Figure 4. Figure 4 is a partial cross section of a fluid handling structure 12 of an embodiment of the invention. It will be seen that the distance between the substrate W and different portions 141, 142, 145, 144 of the bottom surface of the fluid handling structure 12 radially outwards of the and the substrate W varies with radial position relative to the centre of the immersion space 11. The inner portion 144 of the bottom surface of the fluid handling structure 12 is closest to the substrate W. The liquid supply openings 23, fluid extraction openings 32 and gas supply openings 26 are provided in the inner portion 144 of the bottom surface. A first outer portion 141 of the bottom surface is spaced further away from the substrate W than the inner portion 144 and the barrier 143 projects from the first outer portion 141 towards the substrate W. Further gas supply openings 27 are provided in an intermediate portion 145 of the bottom surface of fluid handling structure 12. The distance between the substrate W and the intermediate portion 145 is greater than the distance between the substrate W and inner portion 144 but less than the distance between the substrate W and the first and second outer portions 141, 142.

The effect of the barrier 143 is to cause a pressure drop so that there is a flow of air, indicated by arrow A, beneath the barrier 143, i.e. between the barrier 143 and the substrate W, toward the centre of the immersion space 11. This flow of air reduces outward flow of the soluble gas 140 and contains the soluble gas 140 so that it can be extracted through gas recovery openings 28. The barrier also forms an additional obstacle to flow of the soluble gas 140 toward the environment. The soluble gas 140 may be denser than air and tend to flow outward near the substrate W. The air flow A created by the barrier 143 close to the substrate W disrupts such outward flow of soluble gas 140.

Desirably, barrier 143 projects towards the substrate W by a distance in the range of from 40% to 99% of the distance between the first outer portion 141 and the substrate W. In this way, a constriction defined by a gap 147 between the substrate W and the barrier 143 is created to enhance the inward air flow A. The inward air flow A helps to control dispersion of the soluble gas 140 and encourage extraction of all of the soluble gas 140 through gas recovery openings 28. More desirably, the distance by which the barrier 143 projects is in the range of from 60% to 90% of the distance between the first outer portion 141 and the substrate W. In this way, the barrier 143 has a sufficient size to form a constriction but does not come too close to the substrate W to create a risk of collision. Additionally, the gap 147 between the barrier 143 and the substrate W does not become too small so as to inhibit flow of air therethrough. If the barrier 143 is located in the second outer portion 142 then it should project by a distance in the range of from 40% to 99%, desirably 60% to 90%, of the distance between the second outer portion 142 and the substrate W for the same reasons. In general, the height of the barrier 143 should be between 40% and 99%, desirably between 60% and 90%, of the gap between the substrate W and the parts of the fluid handling structure 12 adjacent the barrier 143

Desirably, the inner portion 144 of the fluid handling structure 12 is the portion of the fluid handling structure 12 that is closest to the substrate W. That is, the gap 147 between the bottom of the barrier 143 and the substrate W is larger than the distance between the inner portion 144 and the substrate W.

The width of the barrier 143, that is its dimension in the radial direction, may vary. The width of barrier 143 at its bottom end determines the pressure drop that occurs in the gap 147 between the bottom of the barrier 143 and the substrate W. If the width of the barrier 143 at its bottom end is too large, there will be too high a resistance to airflow through the gap 147 so the pressure drop will be too large. A large pressure drop may also affect the pressures below the inner portion 144 and intermediate portion 145 and so adversely affect the dynamics of the fluid handling structure 12. The width of the barrier 143 may be constant. Alternatively, the width of the barrier 143 may vary along its length and/or with distance from the outer portion 141, 142.

Desirably, the barrier 143 is positioned at a radial distance from the gas recovery openings 28 in the range of from about 1 mm to about 5 mm. The barrier 143 should not be too close to the gas recovery openings 28 so that there is some volume to accommodate gas flows and fluctuations in the volume of the soluble gas 140. The barrier 143 should not be too far from the gas recovery openings 28 that the air flow A underneath the barrier 143 has dissipated before it reaches the location of the soluble gas 140. The distance between the barrier 143 and the gas recovery openings 28 may vary along the length of the barrier 143.

Various different arrangements and shapes of barrier 143 are possible and a few are illustrated in Figures 5 to 11.

Figure 5 shows a fluid handling structure 12 having two barriers 143a, 143b. One of the barriers 143a may be provided on second outer portion 142 whilst the other barrier 143b may be provided on first outer portion 141. Barrier 143b establishes an inward air flow which is accelerated by barrier 143a.

Figure 6 shows a fluid handling structure 12 having a barrier 143c that has a flat, vertical inner surface and a curved outer surface. This arrangement provides a variable width gap between the bottom of the barrier 143c and the substrate W. The shape of the curved outer surface of barrier 143c can be modified to provide a desired airflow and in particular to minimise turbulence.

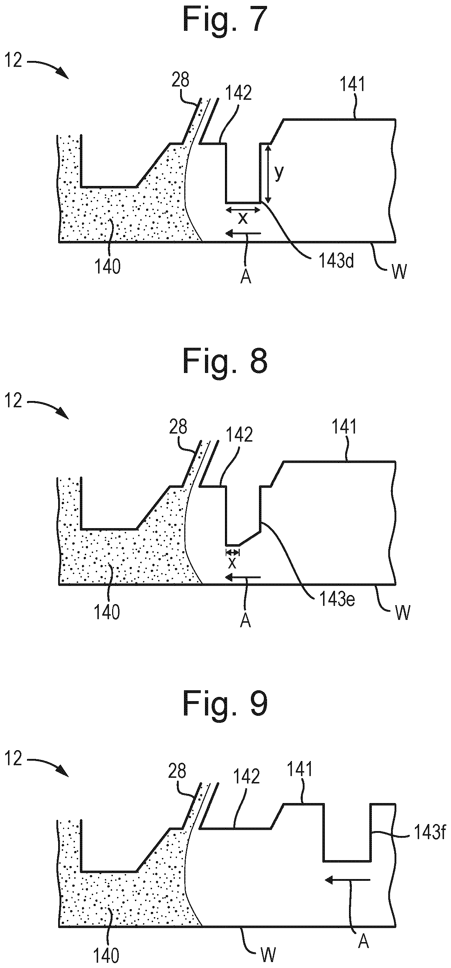

Figure 7 depicts a fluid handling structure 12 having a single barrier 143d that is provided on the second outer portion 142 of the bottom surface of the fluid handling structure 12. Barrier 143d can therefore be located close to gas recovery openings 28. Figure 7 also indicates the width of the barrier 143d as x and the depth of the barrier 143d, i.e. the distance by which it projects from the second outer portion 142, as y. The width and depth of the barrier 143d may be determined by simulation or experimentation to have the desired effect. In particular, it may be desirable to take into account the forces generated on the substrate W by the air flow A.

Figure 8 depicts a fluid handling structure 12 having a barrier 143e which has a bottom profile comprising a horizontal region of width x and a sloped region. The sizes and angles of the horizontal portion and sloped portion may be determined to provide a desired pressure drop and minimise turbulence.

Figure 9 depicts a fluid handling structure 12 having a single barrier 143f provided on the first outer portion 141. Barrier 143f is quite short and quite wide, having an aspect ratio in cross-section close to 1 or greater than 1. Such a barrier 143f may be easier to manufacture.

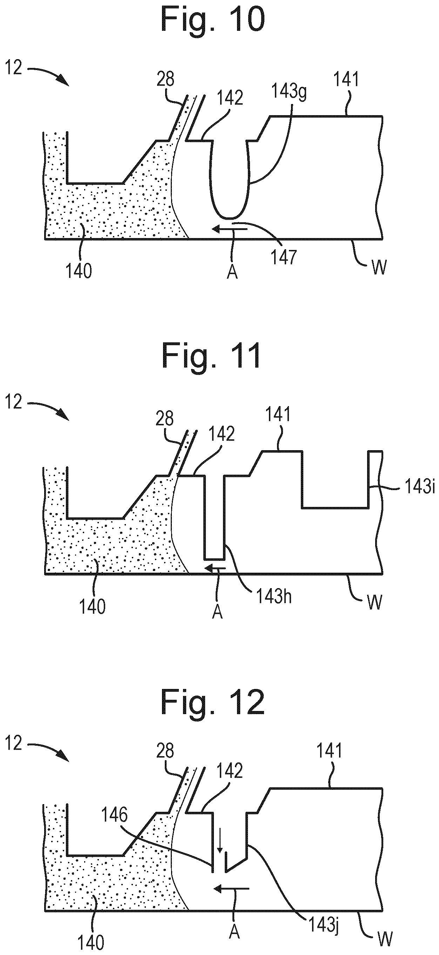

Figure 10 depicts a fluid handling structure 12 having a barrier 143g that has a fully curved profile. Such a fully curved profile can be advantageous in minimising the pressure drop across gap 147. Barrier 143g may be provided at any convenient location in the first outer portion 141 or second outer portion 142.

Figure 11 depicts a fluid handling structure 12 that has a first barrier 143h provided on the second outer portion 142 and a second barrier 143i provided on first outer portion 141. Barrier 143h is comparatively tall and thin, that is having an aspect ratio (width divided by height) much less than 1. Barrier 143i is comparatively short and wide, i.e. having an aspect ratio greater than 1. Barriers 143h and 143i work together to create an inward airflow. The relative sizes and positions of the barriers 143h, 143i can be selected to provide the desired effect.

In order to further control the flow of soluble gas 140, one or more air supply openings 146 can be provided in the fluid handling structure 12 in order to supply air at one or more locations radially outward of the gas recovery openings 28. Supplying additional air radially outwardly of the gas recovery openings 28 further encourages extraction of the soluble gas 140 through the gas recovery openings 28. Figures 12 to 19 depict various arrangements of air supply openings 146 in embodiments of the invention but other arrangements are of course possible. In some cases, air supply opening 146 may instead be used to extract air and other gases. Where there are multiple air supply openings 146, some may be used for supply and some for extraction. Specific openings may be used for supply and extraction at different times under the control of controller 500. Desirably, the rate of extraction of gas through any of air supply openings 146 that are used for extraction is less than the rate of extraction through gas recovery openings 28.

Figure 12 depicts a fluid handling structure 12 in which an air supply openings 146 are provided in the bottom surface of barrier 143j. The bottom surface of barrier 143j is sloped so that the lowest point of barrier 143j is at its inner edge, where air supply openings 146 are provided. Air supplied through air supply openings 146 helps to ensure that the soluble gas 140 is contained and extracted through gas recovery openings 28.

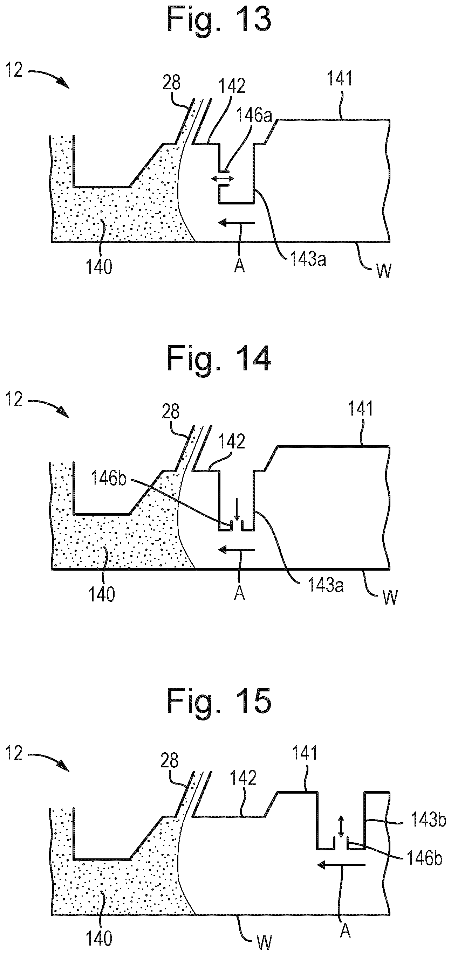

Figure 13 depicts a fluid handling structure 12 in which an air supply opening 146a is provided in the inner side surface of barrier 143a. Barrier 143a is provided on second outer portion 142 close to gas recovery openings 28. Air supplied through air supply openings 146a helps to ensure a good flow rate through gas recovery openings 28 ensuring that the soluble gas 140 is extracted.

Figure 14 depicts a fluid handling structure 12 in which air supply openings 146b are provided in the bottom surface, that is the surface facing the substrate W, of barrier 143a. Air supply openings 146b in this position can assist in creating a sufficient air flow A towards the centre of the fluid handling structure 12.

Figure 15 likewise shows a fluid handling structure 12 in which an air supply opening 146b is provided in a barrier 143b. Barrier 143b is provided on first outer portion 141 and its lower surface is relatively far from the substrate W. Therefore, an increased supply of air through air supply opening 146b may be desirable to ensure a sufficient flow of air A toward the centre of the fluid handling structure 12.

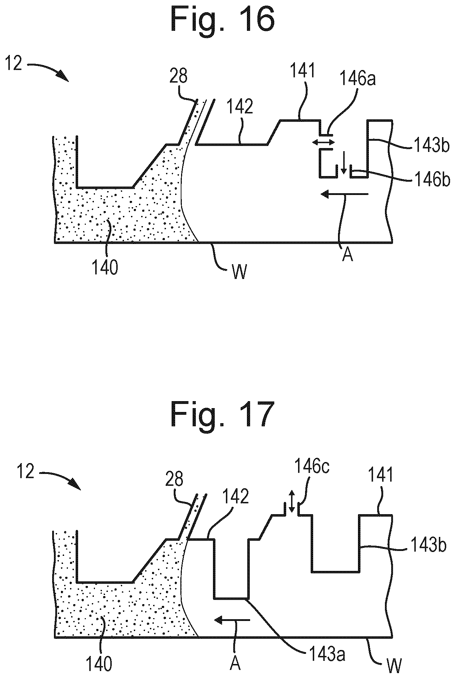

Figure 16 depicts a fluid handling structure 12 in which air supply openings 146a, 146b are provided in both the inner side surface and bottom surface of barrier 143b. This arrangement combines the benefits of the arrangements of Figures 13 and 14.

Figure 17 depicts a fluid handling structure 12 which has two barriers 143a, 143b and air supply openings 146c located in the first outer portion 141 between barriers 143a, 143b. This arrangement can serve to generate a buffer region of air or to accelerate the air which is pulled towards gas recovery openings 28.

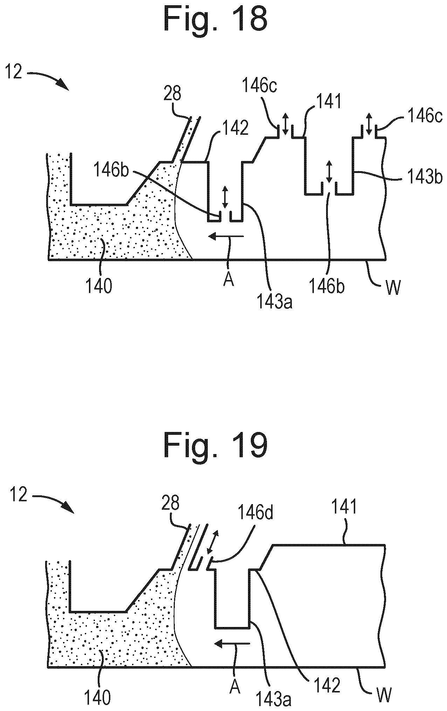

Figure 18 depicts a fluid handling structure 12 also having two barriers 143a, 143b. The fluid handling structure 12 of Figure 18 is provided with air supply openings 146b in the bottom surfaces of barriers 143a, 143b as well as air supply openings 146c in first outer portion 141. Gas supply openings 146c are located between barriers 143a and 143b and also outside barrier 143b. This arrangement enables tuning of the air flows in different parts of the space below the fluid handling structure 12 to ensure the desired effect.

Figure 19 depicts a fluid handling structure 12 having air supply openings 146d located in second outer portion 142 between gas recovery openings 28 and barrier 143a. In this arrangement air can be provided close to gas recovery openings 28 to ensure a high flow rate that entrains and removes soluble gas 140.

In arrangements where air supply openings 146 are provided, the air supply openings 146 may be: a series of discrete openings; or elongate openings such as grooves; or a combination of elongate openings and small discrete openings. Discrete openings may be circular. The size, number and spacing of the air supply openings 146 may be varied around the fluid handling structure 12 in order to provide different air supply rates in different locations.

The supply of air through the air supply openings 146 may be controllable individually or in groups. Control of the air supplied through air supply openings 146 may be dependent upon the movement of the substrate W relative to the fluid handling structure 12, e.g. dependent on the direction and/or speed of the substrate W. For example, the air supplied through air supply openings 146 may be turned on only at the receding side of the fluid handling structure 12. For example, the rate of air supply through air supply openings 146 may be increased with increased speed of movement of the substrate W relative to fluid handling structure 12. Such arrangements ensure that leakage of the soluble gas 140 is minimised in areas where otherwise it would be highest.

In arrangements having air supply openings 146 it is desirable that the rate of extraction of gas through gas recovery openings 28 is greater than the rate of supply of air through all air supply openings 146. Desirably, the rate of gas extraction through gas recovery openings 28 is at least twice, desirably at least four times, the rate of air supply through all air supply openings 146. This may mean that the rate of gas extraction through gas recovery openings 28 is increased by deepening the under-pressure in gas recovery openings 28 depending on the amount of air supplied through air supply openings 146.

It will be understood that the air supplied through air supply openings 146 may be clean dry air (CDA), extremely clean dry air (XCDA) or artificial air. Air supplied through air supply openings 146 may be sourced from an air supply unit of the lithographic apparatus provided for other purposes, e.g. for flushing optical sensors, or may be provided by a dedicated air supply unit. More generally, "air" in this context may refer to any gas or mixture of gases that is less toxic and less disruptive of optical sensors than the soluble gas 140.

In an immersion type lithographic apparatus, the substrate support WT is usually constructed so that the surface of the outer part of the substrate support WT is substantially coplanar with the top surface of the substrate W that is supported by the substrate support WT. Avoiding a change in height between the top surface of the substrate W and the top surface of the outer part of the substrate support WT is important to minimising loss of immersion liquid as the edge of the substrate W passes underneath the immersion space 11.

The substrate support WT is designed to accommodate a substrate W of standard thickness, e.g. 775 µm. For some applications it is desirable to use lithographic techniques to form structures on substrates W that are thicker than standard, e.g. about 900µm. If a thicker substrate W is put into conventional immersion-type lithographic type apparatus, the fly height fh, that is the distance between the bottom surface of the fluid handling structure 12 and the top surface of the substrate W may be reduced, even to zero. Therefore, there is a risk of a collision between the fluid handling structure 12 and the substrate W.

To avoid a risk of collision, the fly height fh of the fluid handling structure 12 may be increased. However, an increased fly height fh may reduce the effectiveness of liquid confinement features, such as gas supply openings 26 and fluid extraction openings 32 in the embodiments of Figures 3 and 4 for example, and may in particular increase the risk of loss of immersion liquid when the edge of the substrate W passes underneath the immersion space 11. To minimise loss of immersion liquid, it is possible to reduce the speed of relative movement between the substrate W and liquid confinement structure 12. However reducing the relative speed has a negative impact on throughput of the lithographic apparatus.

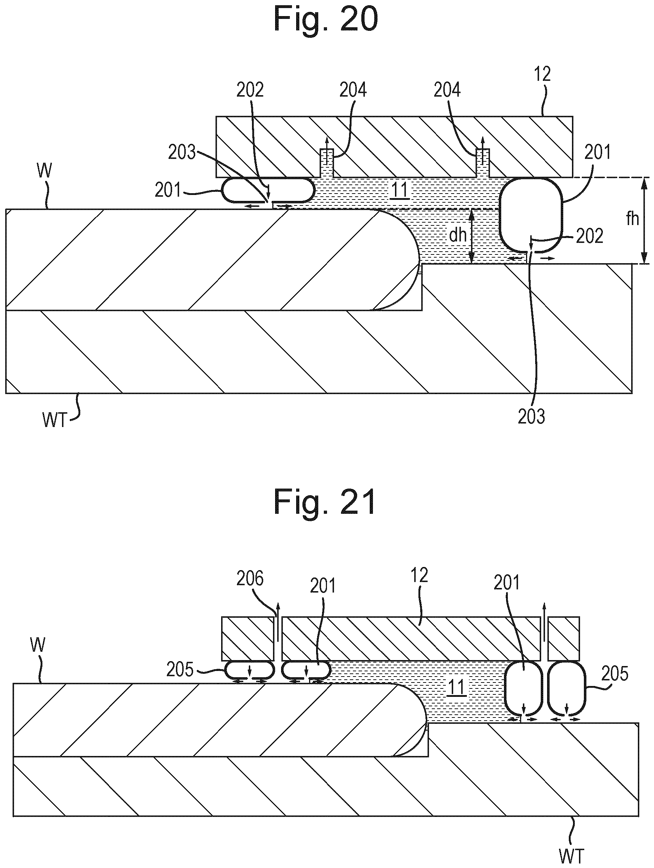

Figure 20 is a schematic cross-section of an embodiment of the invention that is adapted to cope with a thick substrate W. As a result of the increased thickness of the substrate W there is a height difference dh between the top surface of the substrate W and the top surface of the outer part of the substrate support WT. The fluid handling structure 12 accordingly has a fly height fh that is greater than the height different dh by about 40-60µm. Deformable skirt 201 is provided on the lower surface of fluid handling structure 12 surrounding the immersion space 11 as an example of a deformable seal.

Deformable skirt 201 is hollow with an opening or series of openings 203 in its lower surface, facing the top surface of substrate W. Deformable skirt 201 is supplied with gas 202 at a pressure greater than the ambient pressure in the vicinity of the fluid handling structure 12. The gas 202 causes the deformable skirt 201 to inflate and form a seal between the lower surface of the fluid handling structure 12 and the upper surface of the substrate W and the substrate support WT. The flexibility of the deformable skirt 201 is sufficient that it can be compressed to fill the relatively narrow gap between the lower surface of the fluid handling structure 12 and the upper surface of the substrate W but also expand to fill the larger gap between the lower surface of the fluid handling structure 12 and the upper surface of the outer part of the substrate support WT. Deformable skirt 201 therefore forms a seal that helps to confine the immersion liquid to the immersion space 11.

Gas 202 flows out of the openings 203 to form a gas cushion between the bottom of the deformable skirt 201 and the top surface of the substrate W or substrate support WT. The gas cushion both prevents the deformable skirt 201 coming into contact with and damaging structures on the substrate W and prevents immersion liquid from leaking out underneath the deformable skirt 201.

Immersion liquid in the immersion space 11 is continually refreshed through a liquid supply (not shown in Figure 20) and extracted through single phase extractions 204. Continuous refreshing ensures the immersion liquid is clean and removes any bubbles that may get into the immersion space 11. The extraction flow is set such that there is always an outward flow towards the single phase extraction 204.

The deformable skirt 201 may be formed of a flexible material, such as rubber. A fluoroelastomer rubber, e.g. as sold under the name Viton^{™}, is particularly suitable. Deformable skirt 201 may be made of a metal, e.g. manufactured using electroforming technique with a wall thickness of the order of 5 to 50 µm. A deformable skirt 201 may be in the form of a bellows. If the deformable skirt 201 is made of a rubber, or rubber-like material, it may be provided with a metal coating to protect it from corrosion due to the immersion liquid and or DUV radiation. A metal coating may be provided only on the inner side of deformable skirt 201.

The outermost side of the deformable skirt 201 may be less stiff than the inner side so that expansion of the deformable skirt 201 when the fly height fh is reduced primarily occurs in the outward direction.

The gas used to pressurise the deformable skirt 201 is desirably a soluble gas, e.g. CO₂ in the case that the immersion liquid is water.

Figure 21 is a schematic cross-section of a variant of the embodiment of Figure 20. The variant of Figure 21 has a further deformable skirt 205 located outside deformable skirt 201. Further deformable skirt 205 is constructed similarly to deformable skirt 201 and is supplied with gas so as to inflate and/or deflate to accommodate changes in the size of the gap between the lower surface of fluid handling structure 12 and the top surfaces of substrate W or substrate support WT. Further deformable skirt 205 may be connected to the same gas supply as deformable skirt 201 or to an independent gas supply. Further deformable skirt 205 catches any immersion liquid that leaks past deformable skirt 201 so that immersion liquid is not left on the surface of the substrate W. A two phase extraction opening 206 may be provided to remove any immersion liquid that may be in the space between deformable skirt 201 and further deformable skirt 205. The flow to the deformable skirt 201 and further deformable skirt 205 may locally be reduced in advancing movements to remove droplets captured between further deformable skirt 205 and deformable skirt 201.

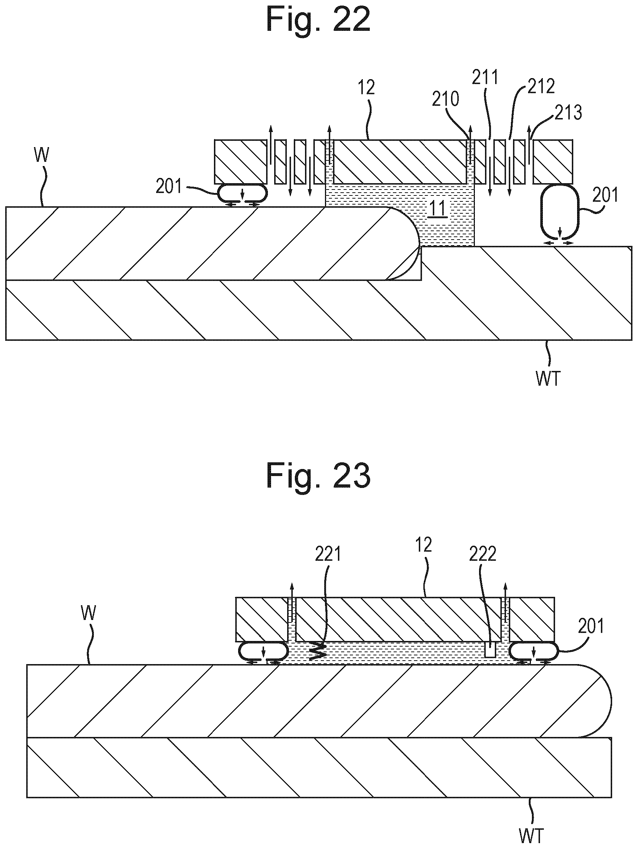

Figure 22 is a cross-section of another variant of the embodiment of Figure 20. In the embodiment of Figure 22, the fluid handling structure 12 has liquid confinement features between the immersion space 11 and the deformable skirt 201. The liquid confinement features may include, outwardly from the immersion space 11: an extraction channel 210 (which may be a single liquid phase extraction or a two phase extraction); a gas supply 211 to form a gas knife; a further gas supply 212 to supply additional gas, e.g. soluble gas; and a gas extraction 213. In this variant the liquid confinement features 210-213 perform the primary function of confining the immersion liquid to the immersion space 11 whilst the deformable skirt 201 functions to catch any liquid that may escape from the immersion space 11, e.g. when crossing the edge of the substrate W.

Figure 23 is a schematic cross-section of another variant of the embodiment of Figure 20. In the variant of Figure 23, a shield is provided to prevent or reduce the amount of ultraviolet radiation reaching the deformable skirt 201. Ultraviolet light, e.g. DUV, that is used to expose the substrate W and passes through the immersion liquid might damage the deformable skirt 201. The shield may take the form of a flexible flap or flange forming a flexible light curtain 221 or a rigid projection 222.

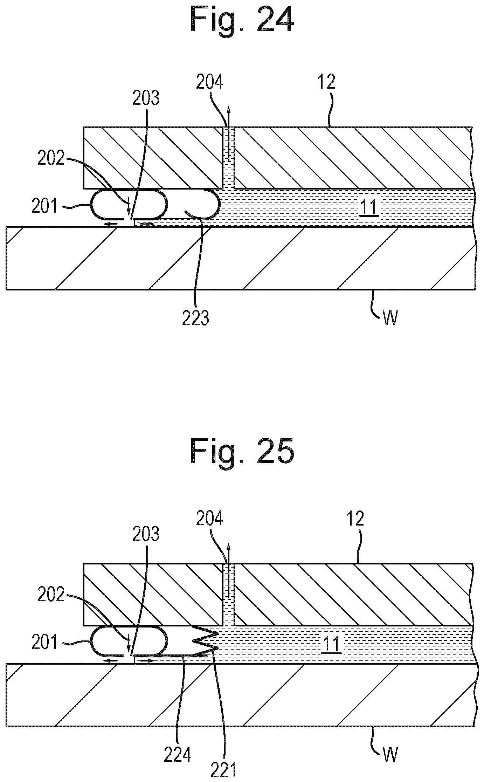

Figure 24 is a schematic cross-section of a part of another variant of the embodiment of Figure 20. In the variant of Figure 4 a flexible light curtain 223 is provided on the inner side of deformable skirt 201. Flexible light curtain 223 is made of a resilient material formed in a curved shape in cross-section, concave on the outside. Such an arrangement can assist with confining the immersion liquid whilst adapting to changes in the fly height fh of the fluid handling structure 12.

Figure 25 is a schematic cross-section of a part of a variant of the embodiment of Figure 20. The variant of Figure 25 has a flexible light curtain 221 that is formed in the shape of a bellows in order to accommodate changes in the fly height fh of fluid handling structure 12. Flexible light curtain 221 may have a similar form to deformable skirt 201. A seal member 224 in the form of an annulus connects flexible light curtain 221 to deformable skirt 201. Seal member 224 is generally flat and much thinner than the fly height fh but may be more rigid than the flexible light curtain 221 and deformable skirt 201. Seal member 224 assists in the confining the immersion liquid 11 by increasing flow resistance to immersion liquid moving under seal member 224 and increasing the blocking effect of the gas exiting openings 203.

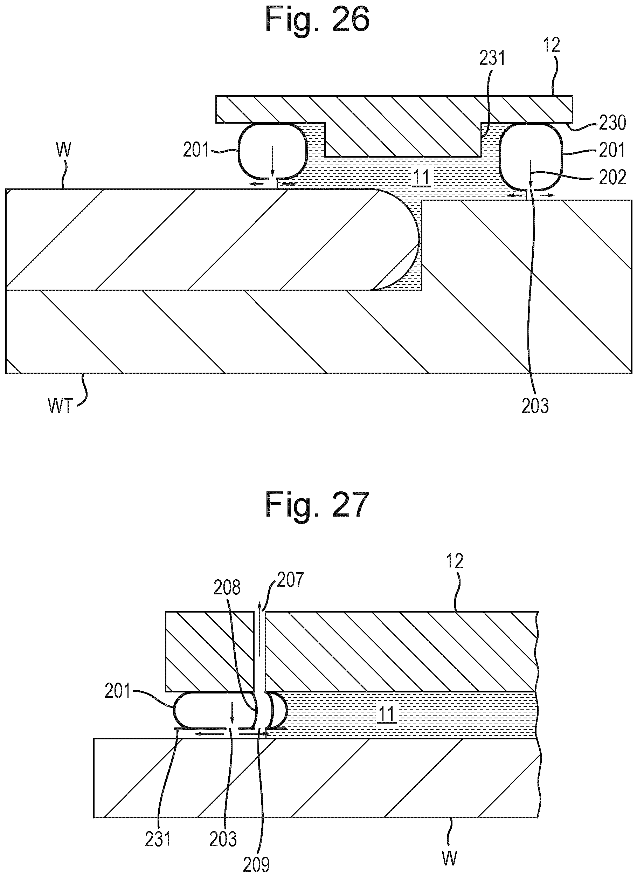

Figure 26 is a schematic side view of a further variant of the embodiment of Figure 20. In the variant of Figure 26, the fluid handling structure 12 is provided with a recessed portion 230 that surrounds a projecting portion 231. The projecting portion 231 accommodates the final element of the projection system PS (which is sometimes referred to as the wet last lens element). The deformable skirt 201 is mounted to the recessed portion 230 of the fluid handling structure 12. This means that the deformable skirt 201 can be made larger in the vertical direction than if it were mounted on a surface substantially coplanar with the bottom of the final element of the projection system PS. By increasing the height of the deformable skirt 201, the amount by which the deformable skirt 201 must deform to accommodate a given height difference dh is a smaller proportion of the uncompressed height of the deformable skirt 201. This means that the deformable skirt 201 can be made of stiffer material and/or have a longer lifetime. All variants of the embodiment having a deformable skirt 201 may have the deformable skirt 201 attached to a recessed portion of the fluid handling structure 12.

Figure 27 is a schematic cross-section of a part of a further variant of the embodiment of Figure 20. In the variant of Figure 20 an extraction 207 is connected to an aperture 209 in the lower surface of deformable skirt 201 via a flexible conduit 208. Using flexible conduit 208, extraction 207 can extract immersion liquid from the gap between the bottom of deformable skirt 201 and the top of substrate W or substrate support WT. Therefore, the meniscus is between the lower surface of deformable skirt 201 and substrate W and has a substantially reduced height of the meniscus of the immersion liquid which reduces the potential for loss of immersion liquid or bubble inclusion. Extraction 207 may be a two-phase extraction. The lower surface of deformable skirt 201 may be formed as a rigid plate 231 in order to increase positional stability of the meniscus of the immersion liquid.

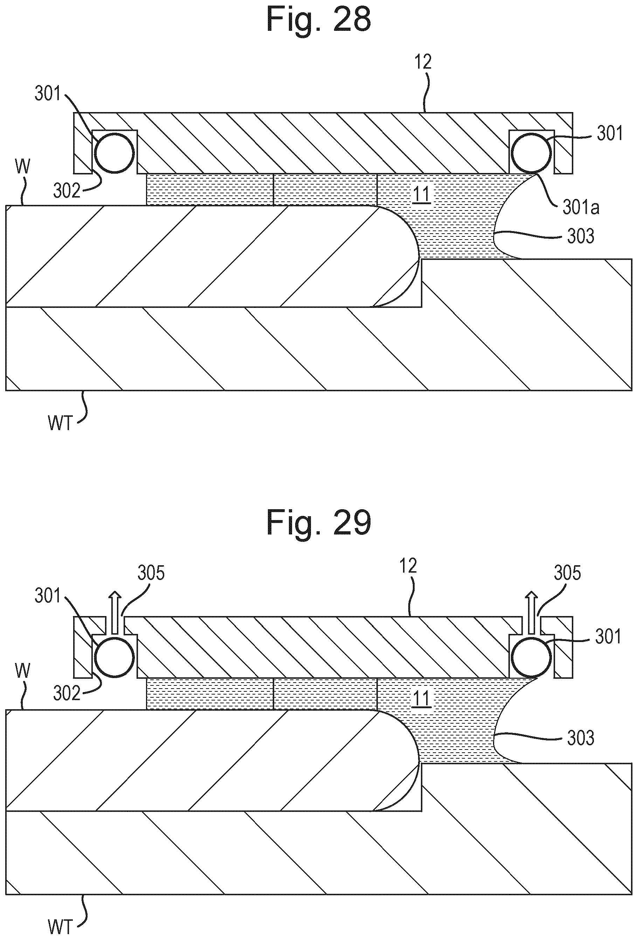

Another approach to addressing the problem of loss of immersion liquid when a fluid handling structure 12 crosses the edge of a thick substrate W will now be described with reference to Figures 28 to 32.

As shown in Figure 28, the fluid handling structure 12 is provided with a woven wire tube 301 that is set in a recess 302 in the lower surface of the fluid handling structure 12. The lowermost part 301a of woven wire tube 301 is desirably flush with or slightly below the bottom surface of fluid handling structure 12.

Woven wire tube 301 can be made from stainless steel or other suitable metal with a coating. Woven wire tube 301 may also be formed of an engineering plastic, such as polyether ether ketone (PEEK). The woven wire tube 301 has a low contact angle to the immersion liquid, e.g. is hydrophilic if the immersion liquid is water. Therefore, the immersion liquid will stick to the surface of the woven wire tube 301. The meniscus 303 is therefore stabilised and loss of immersion liquid when the edge of a thick wafer W passes underneath the fluid handling structure 12 is reduced.

Figure 29 is a schematic cross-section view of a variant of the embodiment of Figure 28. In the variant of Figure 29, an extraction 305 is provided in recess 302. Extraction 305 may be a two-phase extraction or a single-phase extraction. By providing an extraction 305 in recess 302, a flow of air and/or immersion liquid toward and through woven wire tube 301 is created. This flow helps to further stabilise the meniscus 303. Extraction 305 may be controlled so that it is actuated only when required, e.g. when a substrate edge crossing is occurring or imminent. Woven wire tube 301 and the extraction 305 may be segmented so that the extraction 305 is controllable to be operative at different locations around the boundary of the immersion space 11 at different times.

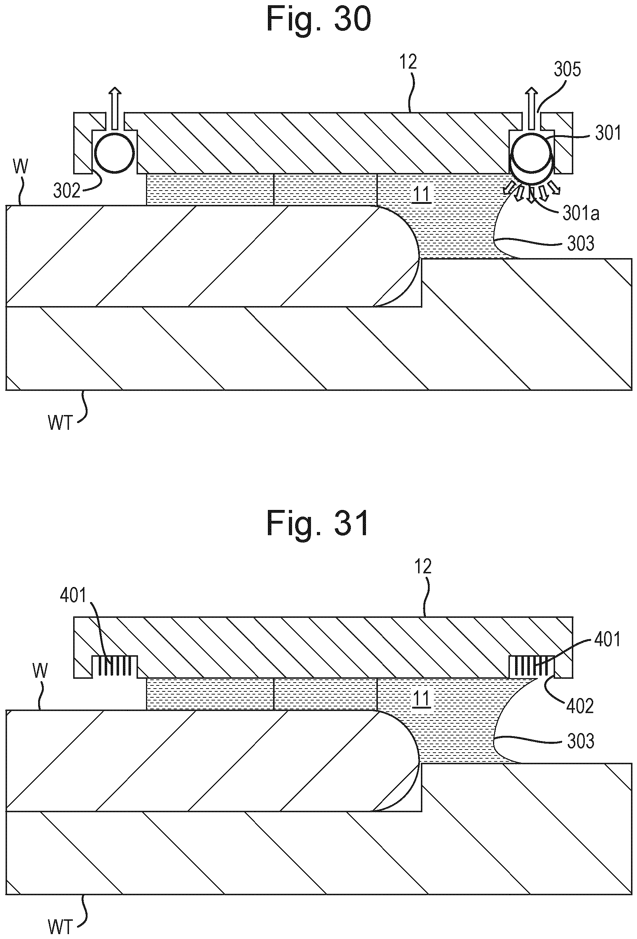

A further variant of the embodiment of Figure 28 is depicted in Figure 30 which is a schematic cross-section of part of the fluid handling structure 12. In this variant, the woven wire tube 301 is actuated to control its size and/or position. For example, woven wire tube 301 may be actuated by controlling its internal pressure, causing it to expand or contract with increases or decreases of internal pressure. In this way, the distance between the lowest part 301a of the woven wire tube 301 and the substrate W or substrate support WT can be varied. Desirably, the woven wire tube 301 may be flexible such that it may be expanded or lowered when not facing a thick substrate W so as to reduce the gap between the lowest part 301a and the substrate W and hence the size of the meniscus 303. The woven wire tube 301 may be divided into segments around the boundary of the immersion space 11 that are separately actuated. In this way, a part of the woven wire tube 301 that is facing a thick substrate W can be deflated and apart of the woven wire tube 301 that is facing the substrate support WT can be inflated in order to minimise the difference in effective fly height. Woven wire tube 301 may have an inner tube and an outer woven part. The inner tube may be gas-tight and inflated to control the position of the lowest part 301a, whilst the outer woven part performs the function of attracting immersion liquid. Extraction 305 may be omitted in this variant.

Another embodiment that addresses the problem of increased loss of immersion liquid at edge crossings with a thick substrate W is depicted in Figure 31 which is a schematic cross-section of a part of the fluid handling structure 12. In this embodiment, micro structures 401 are provided in a trench 402 around the boundary of the immersion space 11. Micro structures 401 are configured to attract immersion liquid through capillary forces. Thereby the meniscus 303 is stabilised. Desirably, the micro structures 401 are provided at the same level as the lowest point of the fluid handling structure 12, e.g., the bottom surface. Desirably, the bottom surface of the fluid handling structure 12 is substantially flat and horizontal.

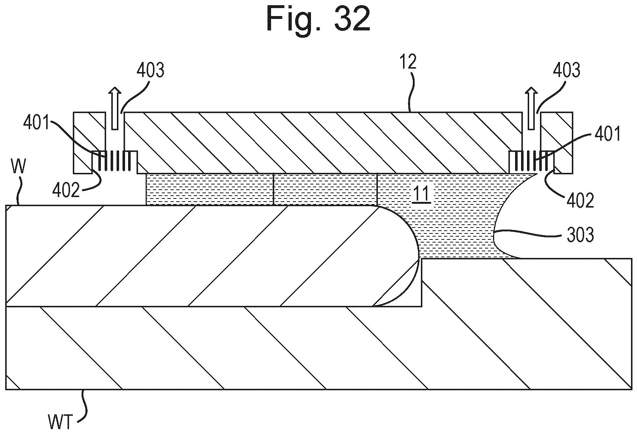

A variant of the embodiment of Figure 31 is depicted in Figure 32 which is a schematic cross-section of a part of fluid handling structure 12. In addition to the micro structures 401, an extraction 403 is provided to extract gas and/or fluid in a single phase or two-phase extraction through the micro structures 401. The creation of a flow of gas and/or fluid helps to stabilise the meniscus 303. The extraction 403 may be selectively actuated, e.g. to be only actuated during a substrate edge crossing. Extraction 403 may be segmented around the boundary of the immersion space 11 to which the immersion liquid is confined with segments being individually controllable. Therefore, different parts of the extraction 403 may be active or inactive or have different extract rates at different positions around the boundary at different times.

Features of the embodiments of Figures 20 to 27 and 28 to 32 may be combined with features of other embodiments.

The present invention may provide a lithographic apparatus. The lithographic apparatus may have any/all of the other features or components of the lithographic apparatus as described above. For example, the lithographic apparatus may optionally comprise at least one or more of a source SO, an illumination system IL, a projection system PS, etc.

Specifically, the lithographic apparatus may comprise the projection system PS configured to project the radiation beam B towards the region of the surface of a substrate W.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Where the context allows, embodiments of the invention may be implemented in hardware, firmware, software, or any combination thereof. Embodiments of the invention may also be implemented by instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate W) or mask (or other patterning device). These apparatus may be generally referred to as lithographic tools. Such a lithographic tool may use ambient (non-vacuum) conditions.

Although specific reference may have been made above to the use of embodiments of the invention in the context of optical lithography, it will be appreciated that the invention, where the context allows, is not limited to optical lithography.

Embodiments of the present invention are further described in the following numbered clauses:
1. A fluid handling structure for an immersion lithographic apparatus, the fluid handling structure configured to confine immersion liquid to an immersion space between a bottom surface of the fluid handling structure and a surface of a substrate and/or a substrate support supporting the substrate, the fluid handling structure comprising:
   at least one liquid supply opening configured to supply immersion liquid to the immersion space;
   at least one fluid extraction opening radially outwards of the liquid supply opening and configured to extract fluid from the immersion space;
   at least one gas supply opening radially outwards of the fluid extraction opening and configured to supply a soluble gas to the vicinity of the immersion space; and
   at least one gas extraction opening radially outwards of the gas supply opening and configured to extract gas from the vicinity of the immersion space;
   wherein the bottom surface has:
      an outer portion radially outward of the gas extraction opening, the outer portion facing the substrate in use and separated from the substrate by a first distance; and
      a barrier projecting from the outer portion of the fluid handling structure toward the substrate by a second distance, the second distance being in the range of from 40% to 99% of the first distance.
2. The fluid handling structure of clause 1, wherein the second distance is in the range of from 60% to 90% of the first distance.
3. The fluid handling structure of clause 1 or 2, wherein the bottom surface has an inner portion, the inner portion being radially inward of the gas extraction opening and being the surface of the fluid handling structure that is closest to the substrate in use.
4. The fluid handling structure of clause 1, 2 or 3, wherein the width of the barrier at the distal end thereof is in the range of from 1 to 100 mm.
5. The fluid handling structure of any of the preceding clauses, wherein the distance between the barrier and the gas extraction opening is in the range of from 1 to 5 mm.
6. The fluid handling structure of any of clauses 1 to 5, wherein the distance between the barrier and the gas extraction opening varies along its length.
7. The fluid handling structure of any of the preceding clauses, wherein the barrier has a constant width.
8. The fluid handling structure of any of clauses 1 to 6, wherein the width of the barrier varies with distance from the outer portion.
9. The fluid handling structure of any of clauses 1 to 6, wherein the width of the barrier varies along its length.
10. The fluid handling structure of any of the preceding clauses, wherein the at least one fluid extraction opening is arranged as a fluid extraction shape defined by a plurality of sides and corners between the plurality of sides and the at least one gas supply opening is arranged as a gas supply shape surrounding the fluid extraction shape, wherein barrier extends along at least 75% of the length of each of the sides.
11. The fluid handling structure of any of the preceding clauses, wherein the at least one fluid extraction opening is arranged as a fluid extraction shape defined by a plurality of sides and corners between the plurality of sides and the at least one gas supply opening is arranged as a gas supply shape surrounding the fluid extraction shape, wherein barrier extends around at least one of the corners.
12. The fluid handling structure of any of the preceding clauses, further comprising at least one further barrier projecting toward the substrate and located radially outwardly of the barrier.
13. The fluid handling structure of any of the preceding clauses, further comprising at least one air supply opening radially outwards of the gas supply opening and configured to supply air to the vicinity of the immersion space.
14. The fluid handling structure of clause 13, wherein the air supply opening is between the gas supply opening and the barrier.
15. The fluid handling structure of clause 13, wherein the air supply opening is in an inner side surface or a bottom surface of the barrier.
16. The fluid handling structure of clause 13, 14 or 15, wherein the or all air supply opening(s) is(are) configured to supply air at a first rate and the or all gas extraction opening(s) is(are) configured to extract gas at a second rate, wherein the second rate is at least twice the first rate.
17. A method of confining immersion liquid to an immersion space between a bottom surface of a fluid handling structure and a surface of a substrate and/or a substrate support supporting the substrate in an immersion lithographic apparatus, the method comprising:
   supplying immersion liquid to the immersion space via at least one liquid supply opening;
   supplying a soluble gas to the vicinity of the immersion space via at least one gas supply opening;
   extracting gas from the vicinity of the immersion space via at least one gas extraction opening radially outwards of the gas supply opening;
   wherein the bottom surface has:
      an outer portion radially outward of the gas extraction opening, the outer bottom surface facing the substrate in use and separated from the substrate by a first distance; and
      a barrier projecting from the outer portion of the fluid handling structure toward the substrate by a second distance, the second distance being in the range of from 40% to 99% of the first distance.
18. A fluid handling structure for an immersion lithographic apparatus, the fluid handling structure configured to confine immersion liquid to an immersion space between a bottom surface of the fluid handling structure and a surface of a substrate and/or a substrate support supporting the substrate, the fluid handling structure comprising:
   a deformable seal provided on the bottom surface of the fluid handling structure substantially surrounding the immersion space and having an interior cavity; and
   a gas supply configured to supply gas to the interior cavity;
   wherein the deformable seal has an opening in a surface facing the substrate and/or a substrate support supporting the substrate such that gas supplied to the interior cavity flows out of the opening.
19. The fluid handling structure according to clause 18, comprising two deformable seals, one inside the other.
20. The fluid handling structure according to clause 19, comprising a fluid extraction opening configured to extract fluid from a space between the two concentric deformable seals.
21. The fluid handling structure according to clause 18, 19 or 20, further comprising a light shield configure to shield the deformable seal from radiation projected through the immersion space.
22. The fluid handling structure according to clause 18, 19, 20 or 21, wherein the (or each) deformable seal may be provided on a recessed portion of the fluid handling structure.
23. The fluid handling structure according to any of clauses 18 to 22, further comprising a liquid extraction opening configured to extract immersion liquid from the immersion space.
24. The fluid handling structure according to any of clauses 18 to 23, further comprising a flexible conduit passing through the deformable seal and configured to extract fluid from a gap between the deformable seal and the substrate and/or a substrate support supporting the substrate.

## Claims

1. A fluid handling structure for an immersion lithographic apparatus, the fluid handling structure configured to confine immersion liquid to an immersion space between a bottom surface of the fluid handling structure and a surface of a substrate and/or a substrate support supporting the substrate, the fluid handling structure comprising:
at least one liquid supply opening configured to supply immersion liquid to the immersion space;
at least one fluid extraction opening radially outwards of the liquid supply opening and configured to extract fluid from the immersion space;
at least one gas supply opening radially outwards of the fluid extraction opening and configured to supply a soluble gas to the vicinity of the immersion space; and
at least one gas extraction opening radially outwards of the gas supply opening and configured to extract gas from the vicinity of the immersion space;
wherein the bottom surface has:
an outer portion radially outward of the gas extraction opening, the outer portion facing the substrate in use and separated from the substrate by a first distance; and
a barrier projecting from the outer portion of the fluid handling structure toward the substrate by a second distance, the second distance being in the range of from 40% to 99% of the first distance.

2. The fluid handling structure of claim 1, wherein the second distance is in the range of from 60% to 90% of the first distance.

3. The fluid handling structure of claim 1 or 2, wherein the bottom surface has an inner portion, the inner portion being radially inward of the gas extraction opening and being the surface of the fluid handling structure that is closest to the substrate in use.

4. The fluid handling structure of claim 1, 2 or 3, wherein the width of the barrier at the distal end thereof is in the range of from 1 to 100 mm.

5. The fluid handling structure of any of the preceding claims, wherein the distance between the barrier and the gas extraction opening is in the range of from 1 to 5 mm.

6. The fluid handling structure of any of claims 1 to 5, wherein the distance between the barrier and the gas extraction opening varies along its length.

7. The fluid handling structure of any of the preceding claims, wherein the barrier has a constant width.

8. The fluid handling structure of any one of claims 1 to 6, wherein the width of the barrier varies with distance from the outer portion, or wherein the width of the barrier varies along its length.

9. The fluid handling structure of any of the preceding claims, wherein the at least one fluid extraction opening is arranged as a fluid extraction shape defined by a plurality of sides and corners between the plurality of sides and the at least one gas supply opening is arranged as a gas supply shape surrounding the fluid extraction shape, wherein barrier extends along at least 75% of the length of each of the sides.

10. The fluid handling structure of any of the preceding claims, wherein the at least one fluid extraction opening is arranged as a fluid extraction shape defined by a plurality of sides and corners between the plurality of sides and the at least one gas supply opening is arranged as a gas supply shape surrounding the fluid extraction shape, wherein barrier extends around at least one of the corners.

11. The fluid handling structure of any of the preceding claims, further comprising at least one further barrier projecting toward the substrate and located radially outwardly of the barrier.

12. The fluid handling structure of any of the preceding claims, further comprising at least one air supply opening radially outwards of the gas supply opening and configured to supply air to the vicinity of the immersion space.

13. The fluid handling structure of claim 12, wherein the air supply opening is between the gas supply opening and the barrier, or wherein the air supply opening is in an inner side surface or a bottom surface of the barrier.

14. The fluid handling structure of claim 12 or 13, wherein the or all air supply opening(s) is(are) configured to supply air at a first rate and the or all gas extraction opening(s) is(are) configured to extract gas at a second rate, wherein the second rate is at least twice the first rate.

15. A fluid handling structure for an immersion lithographic apparatus, the fluid handling structure configured to confine immersion liquid to an immersion space between a bottom surface of the fluid handling structure and a surface of a substrate and/or a substrate support supporting the substrate, the fluid handling structure comprising:
a deformable seal provided on the bottom surface of the fluid handling structure substantially surrounding the immersion space and having an interior cavity; and
a gas supply configured to supply gas to the interior cavity;
wherein the deformable seal has an opening in a surface facing the substrate and/or a substrate support supporting the substrate such that gas supplied to the interior cavity flows out of the opening.
